# EUROPÄISCHE PATENTSCHRIFT

(11) **EP 1 753 025 B1**
(45) Veröffentlichungstag und Bekanntmachung des Hinweises auf die Patenterteilung: **14.10.2009**
(21) Anmeldenummer: 06014878.0
(22) Anmeldetag: 18.07.2006
(51) Int. Cl.: H01L 23/04, H01L 25/07, H01L 23/24

(54) **Leistungshalbleitermodul mit wannenförmigem Grundkörper**
Power semiconductor module with a bowl-shaped support base
Module semiconducteur de puissance avec support de base en forme de cuvette

(30) Priorität: 09.08.2005 DE 102005037522
(43) Veröffentlichungstag der Anmeldung: 14.02.2007
(73) Patentinhaber: Semikron Elektronik GmbH & Co. KG Patentabteilung, 90431 Nürnberg (DE)
(72) Erfinder: Stockmeier, Thomas, Dr., 91054 Erlangen (DE)

(56) Entgegenhaltungen:
- EP-A- 0 727 818
- DE-A1- 3 604 882
- DE-A1- 10 129 006
- DE-A1- 10 333 329
- DE-A1- 19 533 298
- DE-A1- 19 616 195
- US-A- 5 610 799

## Beschreibung

Die Erfindung beschreibt ein Leistungshalbleitermodul bestehend aus einem Gehäuse mit Grundplatte zur Montage auf einem Kühlkörper und mindestens einem darin angeordneten elektrisch isolierenden Substrat. Dieses besteht seinerseits aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weisen derartige Leistungshalbleitermodule Anschlusselemente für externe Last- und Hilfskontakte und auch Verbindungselemente für Verbindungen im Inneren des Leistungshalbleitermoduls auf.

Leistungshalbleitermodule, die Ausgangspunkt dieser Erfindung sind, sind beispielhaft bekannt aus der DE 39 37 045 A1. Hierin ist ein Leistungshalbleitermodul in Form einer Halbbrückenschaltungsanordnung offenbart. Dieses Leistungshalbleitermodul weist als externe Lastanschlusselemente für die beiden Gleichstromanschlüsse und für den Wechselstromanschluss flächig ausgestaltete Metallformkörper auf. Diese als Anschlussbänder ausgebildeten Metallformkörper sind zur Reduktion parasitärer Induktivitäten im Inneren des Moduls möglichst eng benachbart zueinander angeordnet. Die EP 0 727 818 A1 offenbart ein ähnliches Leistungshalbleitermodul mit einer Grundplatte, einem Gehäuse und einem Substrat, wobei das Innere des Gehäuses mit einer Isolationsmasse gefüllt, ist.

Gemäß der als Stand der Technik genannten Druckschrift sind die Substrate derartiger Leistungshalbleitermodule ausgebildet als isolierende Substrate bestehend aus einem Isolierstoffkörper als Trägermaterial und zur elektrischen Isolierung zu einer Grundplatte oder zu einem Kühlkörper. Dieser Isolierstoffkörper besteht nach dem Stand der Technik aus einer Industriekeramik beispielhaft Aluminiumoxid oder Aluminiumnitrit. Auf diesem Isolierstoffkörper auf dessen der Grundplatte abgewandten ersten Hauptfläche befinden sich eine Mehrzahl von gegeneinander elektrisch isolierten metallischen Verbindungsbahnen. Auf diesen wiederum sind die Leistungshalbleiterbauelemente angeordnet.

Meist weist der Isolierstoffkörper auf seiner der Grundplatte oder dem Kühlkörper zugewandten zweiten Hauptfläche ebenfalls eine metallische Schicht gleichen Materials und gleicher Dicke wie die Verbindungsbahnen auf der ersten Hauptfläche auf. In der Regel ist diese Schicht allerdings nicht in sich strukturiert, da sie beispielhaft der Lötverbindung zu einer Grundplatte dient. Die Verbindungsbahnen sowie die metallische Schicht der zweiten Hauptfläche besteht vorzugsweise aus nach dem DCB (direct copper bonding) Verfahren aufgebrachten Kupfer.

Zur Verbindung der genannten Verbindungsbahnen mit den Leistungshalbleiterbauelementen sind Verbindungselemente angeordnet, die nach dem Stand der Technik gemäß DE 39 37 045 A1 als Drahtbondverbindungen ausgebildet sind. Weiterhin sind auf diesen Verbindungsbahnen und mit ihnen verbunden die Anschlusselemente, die als Metallformkörper ausgebildet sind, zur externen elektrischen Verbindung des Leistungshalbleitermoduls angeordnet.

Nach dem Stand der Technik ist die Grundplatte derartiger Leistungshalbleitermodule ausgebildet als ein quaderförmiger Metallformkörper, vorzugsweise aus Kupfer zur besseren Wärmeabfuhr von dem Substrat zu einem Kühlkörper. Auf dieser quaderförmigen Grundplatte ist beispielhaft mittels einer Klebeverbindung das Gehäuse angeordnet. Diese umschließt somit das Substrat. Zur inneren Isolation des Leistungshalbleitermoduls ist dieses mit einem Füllstoff mit einer hohen Dielektrizitätskonstante gefüllt. Hierfür haben sich Silikonvergussmassen bewährt, da sie einfach zu Handhaben sind und eine für die innere Isolation ausreichende Dielektrizitätskonstante aufweisen.

Derartige Vergussmassen werden nach dem Stand der Technik in flüssiger, meist zähflüssiger, Form in das Leistungshalbleitermodul eingebracht und vernetzen dort unter Bildung einer zähelastischen Masse. Die oben genannte Verbindung der Grundplatte zu dem Gehäuse muss daher eine nachteiligerweise ausreichend Dichtigkeit gegen das Austreten von Vergussmasse aus dem Gehäuse aufweisen. Weiterhin sind die Gehäuse häufig mehrstückig ausgebildet, wobei eine erster Gehäuseteil das Substrat und somit die Vergussmasse rahmenartig umschließt und ein weiterer Gehäuseteil einen Deckel des Leistungshalbleitermoduls bildet.

Weiterhin nachteilig am Stand der Technik ist, dass das Substrat auf der Grundplatte mittels einer Lötverbindung fixiert wird. Bei einer nicht ausreichenden Stabilität, die mit einer nicht ausreichenden Dicke der Grundplatte einher geht, führt diese Lötverbindung zu einer Durchbiegung der Grundplatte.

Die DE 196 16 195 A1 offenbart eine Zündvorrichtung für einen Verbrennungsmotor, wobei ein Teil dieser Schaltungsanordnung in einem schalenförmigen Kühlblech aus Kupfer angeordnet und dort vergossen ist. Weiterhin ist aus der US 5,610,799 und der DE 101 29 006 A1 eine Schaltungsanordnung mit einem becherförmigen Gehäuse bekannt, in welchem eine vergossene Schaltung angeordnet ist.

Der Erfindung liegt die Aufgabe zugrunde ein Leistungshalbleitermodul vorzustellen, wobei die Abdichtung gegen ein Ausfließen der Vergussmasse bei der Herstellung mit einfachen konstruktiven Mitteln sichergestellt ist, die Stabilität der Grundplatte erhöht wird und gleichzeitig die gesamte Ausgestaltung des Leistungshalbleitermoduls vereinfacht wird.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von einem Leistungshalbleitermodul mit einer Grundplatte zur Montage auf einem Kühlkörper. Dieses Leistungshalbleitermodul weist mindestens folgende Komponenten auf: ein Gehäuse, Anschlusselemente für Last- und Hilfsanschlüsse, ein Substrat mit Verbindungsbahnen, ein Leistungshalbleiterbauelement und ein Verbindungselement zur internen Verbindung des Leistungshalbleiterbauelements.

Die Anschlusselemente für Last- und Hilfskontakte führen aus dem Gehäuse heraus und dienen der elektrischen Verbindung der im Gehäuseinneren angeordneten Komponenten. Das zur Grundplatte elektrisch isolierend ausgebildete Substrat besteht seinerseits aus einem Isolierstoffkörper, vorzugsweise einer Industriekeramik, und hierauf, auf dessen der Grundplatte oder dem Kühlkörper abgewandten ersten Hauptfläche befindlich, einer Mehrzahl von gegeneinander elektrisch isolierten metallischen Verbindungsbahnen. Auf diesen Verbindungsbahnen sind Leistungshalbleiterbauelemente angeordnet und schaltungsgerecht mittels Verbindungselementen mit Verbindungsbahnen und / oder weiteren Leistungshalbleiterbauelementen und / oder Anschlusselementen verbunden.

Zur inneren elektrischen Isolation weist das Leistungshalbleitermodul eine Vergussmasse auf. Die Grundplatte des Leistungshalbleitermoduls ist hier als Grundkörper ausgebildet, der in einem Teil wannenförmig ausgestaltet und somit aus einen Bodenbereich und Seitenwände eine Wanne ausbildet um diese Vergussmasse aufzunehmen. Diese Wanne ist hierzu derart ausgebildet, dass ihre Ränder höher sind als der Pegel der Vergussmasse im Inneren der Wanne.

Vorteilhaft an der genannten Ausgestaltung des Leistungshalbleitermoduls ist, dass somit eine aufwändige Abdichtung zwischen dem Grundkörper und dem Gehäuse entfallen kann. Vorteilhafterweise kann das Gehäuse einstückig ausgebildet werden, da in einem Fertigungsprozess erst das Substrat mit den Leistungshalbleiterbauelemente in dem wannenartigen Teil des Grundkörpers angeordnet werden kann, anschließen die Vergussmasse eingebracht werden kann und anschließend nur noch ein Gehäuse, als Deckel wirkend, angeordnet werden kann.

Weiterhin vorteilhaft ist, dass durch die Ausbildung der Wanne des Grundkörpers eine erhöhte Stabilität erlangt und somit in seinem Bodenbereich im Vergleich zum Stand der Technik dünner gestaltet werden kann. Weiterhin weist das Gehäuse erfindungsgemäße Fortsetzungen ins Innere des Leistungshalbleitermoduls auf, wobei diese Fortsetzungen eine durchgehende Ausnehmung zur Anordnung einer Schraubverbindung zur Befestigung des Leistungshalbleitermoduls auf dem Kühlkörper aufweisen.

Der erfinderische Gedanke wird anhand der Fig. 1 bis 4 näher erläutert.

Fig. 1 zeigt ein Leistungshalbleitermodul nach dem Stand der Technik.

Fig. 2 zeigt eine Ausgestaltung eines nicht erfindungsgemäßen Leistungshalbleitermoduls.

Fig. 3 zeigt eine Ausgestaltung eines erfindungsgemäß weitergebildeten Leistungshalbleitermoduls.

Fig. 4 zeigt eine Ausgestaltung eines nicht erfindungsgemäßen Leistungshalbleitermoduls.

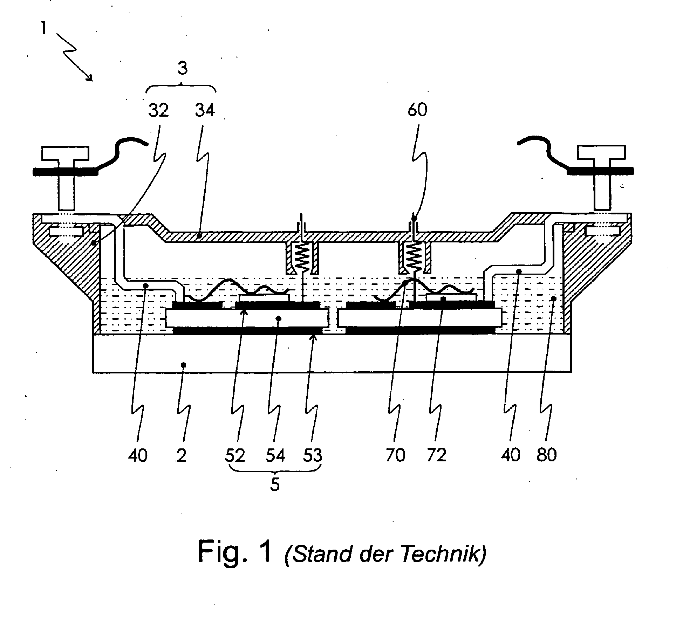

Fig. 1 zeigt ein Leistungshalbleitermodul (1) nach dem Stand der Technik mit einer Grundplatte (2) im Längsschnitt. Auf dieser Grundplatte (2) angeordnet sind ein rahmenartige Gehäuse (3) sowie zwei Substrate (5). Jedes Substrat (5) besteht aus einem Isolierstoffkörper (54) sowie aus metallischen Kaschierungen, die auf beiden Hauptflächen angeordnet sind. Die der Grundplatte (2) zugewandte metallische Kaschierung (53) ist flächig ausgebildet und nicht strukturiert. Mittels einer Lötverbindung zwischen dieser Kaschierung (53) und der Grundplatte (2) werden diese zueinander fixiert. Demgegenüber ist die dem Leistungshalbleitermodulinneren zugewandte Kaschierung in sich strukturiert und bildet somit die Verbindungsbahnen (52) des Substrats (5) aus.

Auf diesen Verbindungsbahnen (52) sind die Leistungshalbleiterbauelemente (56) angeordnet. Die elektrischen Anschlusselemente bilden die Leistungs- (40) und die Hilfsanschlüsse (60). Die Hilfsanschlüsse (60) zur Druckkontaktierung sind als Kontaktfedern ausgebildet und bedürfen einer Druckbeaufschlagung zur sicheren elektrischen Kontaktierung. Die schaltungsgerechte Verbindung der Leistungshalbleiterbauelemente (56) mit den Verbindungsbahnen (52) ist als Bondverbindung (70) ausgebildet.

Die Anschlusselemente (40) der Leistungsanschlüsse werden gebildet durch Metallformkörper, die an ihrem einen Ende löttechnisch mit der zugeordneten Verbindungsbahn (52) des Substrats (5) verbunden sind und an ihrem anderen Ende eine Ausnehmung zur Schraubverbindung aufweisen.

Das Gehäuse des Leistungshalbleitermoduls (1) ist zweistückig ausgebildet. Ein erster rahmenartiger Teil (32) des Gehäuses (3) umschließt die Substrate (5), während ein zweiter Teil (34) den Deckel des Gehäuses (3) bildet. Dieser Deckel (34) weist Ausformungen zur Positionierung und Fixierung der Hilfsanschlüsse (60) auf. Die Leistungsanschlüsse (40) werden jeweils in einer Ausformung des rahmenartigen Gehäuseteils (32) fixiert. Dieser rahmenartige Teil (32) des Gehäuses (3) ist auf der Grundplatte (2) mittels einer Klebeverbindung angeordnet. Diese Klebeverbindung verhindert, dass während der Herstellung des Leistungshalbleitermoduls (1) die zu diesem Zeitpunkt flüssige Vergussmasse (80) zur inneren elektrischen Isolierung aus dem Leistungshalbleitermodul (1) austreten kann.

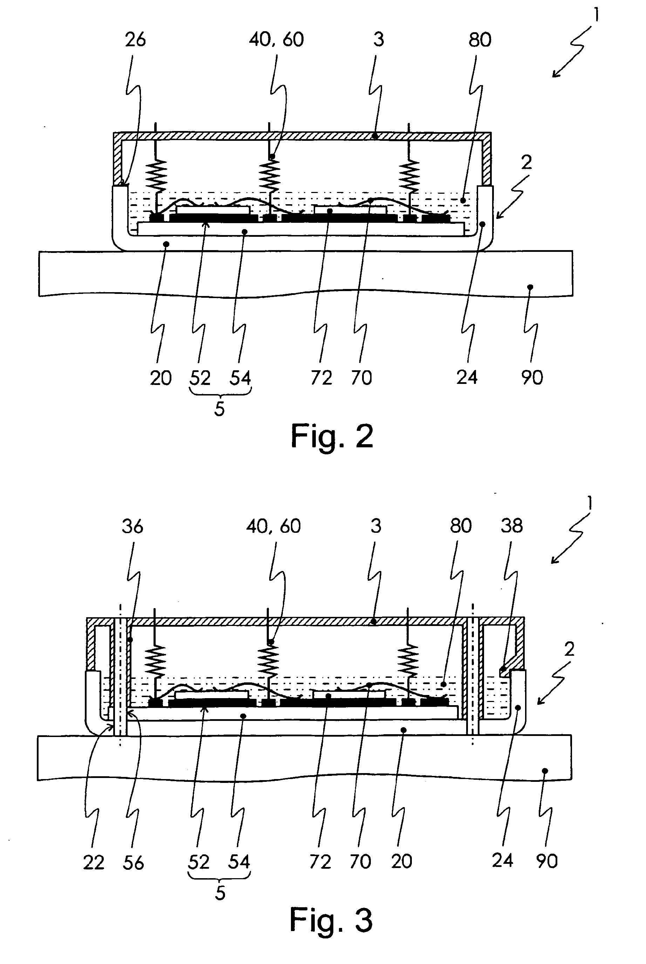

Fig. 2 zeigt zum Verständnis der Erfindung eine nicht erfinderische Ausgestaltung eines Leistungshalbleitermoduls (1) zur Montage auf einem Kühlkörper (90) im Längsschnitt. Dargestellt ist hierbei ein in einem Tiefziehverfahren hergestellter metallischer Grundkörper (2). Dieser weist in seinem Randbereich eine umlaufende Seitenwand (24) auf womit diese gemeinsam mit dem Bodenbereich ausbildet (20) eine Wanne . Diese Wanne umschließt ein darin angeordnetes Substrat (5) an fünf Seiten. Als Werkstoff des Grundkörpers (2) sind besonders geeignet Kupfer wegen seiner hervorragenden Wärmeleitfähigkeit aber auch Aluminium, wegen seiner vielfältigen Gestaltbarkeit. Vorzugsweise ist dieser Grundkörper (2), speziell bei Leistungshalbleitermodulen (1) geringerer Leistung, direkt mittels einer Klebeverbindung mit dem Kühlkörper (90) verbunden. Dies ist vorteilhaft, da somit keine weiteren Kraft einleitenden Bauteile wie Schraubverdingungen oder Klemmeinrichtungen zur Befestigung notwendig sind und gleichzeitig beim Einsatz geeigneter Kleber eine guter Wärmeübergang vom Leistungshalbleitermodul (1) auf den Kühlkörper (90) gewährleistet ist.

Das Substrat (5) wird gebildet aus einem bekannten Isolierstoffkörper (54) mit metallischen Verbindungsbahnen (52) auf der dem Leistungshalbleitermodulinneren zugewandeten Seite. Vorteilhafterweise weist das Substrat (5) auf seiner Unterseite keine weitere metallische Schicht, vergleichbar den Verbindungsbahnen (52), auf, da das Substrat (5) auf dem Bodenbereich (20) des Grundkörpers (2) mittels einer großflächigen Klebeverbindung fixiert ist.

Auf den Verbindungsbahnen (52) des Substrats (5) sind Leistungshalbleiterbauelemente (72) angeordnet und schaltungsgerecht nach dem Stand der Technik verbunden. Zur inneren elektrischen Isolation weist das Leistungshalbleitermodul (1) eine Vergussmasse (80) mit geeigneter Dielektrizitätskonstante, beispielhaft ein Silikonkautschuk, auf. Dieser Silikonkautschuk (80) weist einen Pegelstand also eine Höhe über dem Bodenbereich (20) des Grundkörpers (2) auf, die geringer ist als die Höhe der Seitenwände (24). Somit ist gewährleistet, dass keine Vergussmasse (80) aus dem Leistungshalbleitermodul (1) austreten kann.

Die nach außen führenden Anschlusselemente (40, 60) sowohl der Last-, wie auch der Hilfsanschlüsse sind hierbei ausgebildet als Kontaktfedern. Diese sind in dem einstückig ausgebildeten Kunststoffgehäuse (3) angeordnet. Das Gehäuse (3) ist auf die Randbereiche (26) der Seitenwände (24) des Grundkörpers (2) mittels einer Klebeverbindung fixiert. Alternativ können auch geeignete Schnapp- Rastverbindungen zwischen dem Grundkörper (2) und dem Gehäuse (3) vorgesehen sein.

Fig. 3 zeigt eine Ausgestaltung eines erfindungsgemäß weitergebildeten Leistungshalbleitermoduls (1). Das Substrat (5) und die nach außen führenden Anschlusselemente (40, 60) sind hierbei analog zu Fig. 2 ausgebildet. Das einstückige Kunststoffgehäuse (3) weist hier allerdings zusätzlich Fortsetzungen (36) ins Innere des Leistungshalbleitermoduls (1) auf. Diese Fortsetzungen (36) weisen ihrerseits eine durchgehende Ausnehmung zur Anordnung einer Schraubverbindung zur Befestigung des Leistungshalbleitermoduls (1) auf dem Kühlkörper (90) auf.

Die Fortsetzungen (36) reichen entweder bis zum Bodenbereich (20) des Grundkörpers (2) und / oder bis auf das Substrat (5). Im erstgenannten Fall weist der Bodenbereich (20) des Grundkörpers (2) in der Flucht zur Ausnehmung der Fortsetzung (36) des Gehäuses (3) ebenfalls eine Ausnehmung (22) auf. Im zweitgenannten Fall weisen sowohl das Substrat (5) als auch der Bodenbereich (20) des Grundkörpers (2) Ausnehmungen (22, 56) auf.

Da bei dieser Ausgestaltung des Leistungshalbleitermoduls (1) über das Gehäuse (3) Druck auf das Substrat (5) die Seitenwände (24) und /oder den Bodenbereich (20) des Grundkörper (2) eingeleitet wird und eine Abdichtung gegen Ausfließen von Vergussmasse (80) nicht notwendig ist kann auf eine Klebeverbindung zwischen dem Gehäuse (3) und des Grundkörpers (2) verzichtet werden. Vorteilhaft ist noch eine geringe Überdeckung (38) der Seitenwände (24) durch das Gehäuse (3).

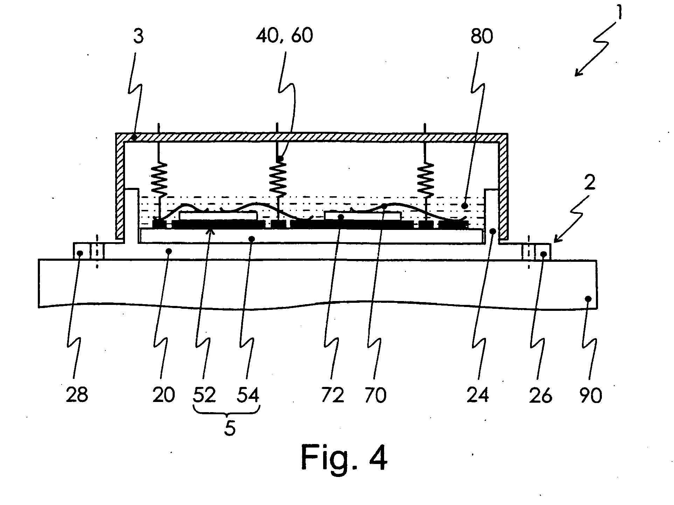

Fig. 4 zeigt zum Verständnis der Erfindung eine weitere nicht erfinderische Ausgestaltung eines Leistungshalbleitermoduls (1), wobei das Substrat (5) und die nach außen führenden Anschlusselement (40, 60) wiederum analog zu Fig. 2 ausgebildet sind. Der durch Kaltfließpressen ausgebildete Grundkörper (2) weist außerhalb des wannenartigen Teils noch Bereiche (28) mit Ausnehmungen zur Schraub-, oder Klemmverbindung mit dem Kühlkörper (90) auf.

Weiterhin überlappt hierbei das Gehäuse (3) die Seitenwände (24) des Grundkörpers (2) um Anforderungen an die äußere elektrische Isolation zu erfüllen. Als Verbindungstechnik zwischen dem Kunststoffgehäuse (3) und dem Grundkörper (2) eignet sich hier wiederum eine Klebeverbindung besonders.

## Patentansprüche

1. Leistungshalbleitermodul (1) mit einem Grundkörper (2) zur Montage auf einem Kühlkörper (90) mindestens bestehend aus einem Gehäuse (3), nach außen führenden Anschlusselementen (40, 60), mindestens einem innerhalb des Gehäuses (3) angeordneten elektrisch isolierenden Substrat (5), das seinerseits besteht aus einem Isolierstoffkörper (54) und auf dessen dem Grundkörper (2) abgewandten ersten Hauptfläche befindlichen Mehrzahl von gegeneinander elektrisch isolierten metallischen Verbindungsbahnen (52), hierauf angeordnet mindestens ein Leistungshalbleiterbauelement (72) mit mindestens einem Verbindungselement (70)
wobei der Grundkörper (2) einen Teil aufweist, der wannenförmig ausgebildet ist und das mindestens eine Substrat (5) derart umschließt, dass die Seitenwände (24) dieser Wanne eine größere Höhe aufweisen, als die Pegelhöhe einer Isolationsmasse (80) im Inneren der Wanne, die somit auch das mindestens eine Leistungshalbleiterbauelement (72) und das mindestens eine Verbindungselement (70) umschließt, und
wobei das Gehäuse (3) die Seitenwände der Wanne am Randbereich oder an der äußeren Fläche berührt, wodurch das Gehäuse als Deckel des Leistungshalbleitermoduls wirkt und weiterhin Fortsetzungen (36) ins Innere des Leistungshalbleitermoduls (1) aufweist, und diese Fortsetzungen (36) eine durchgehende Ausnehmung zur Anordnung einer Schraubverbindung zur Befestigung des Leistungshalbleitermoduls (1) auf dem Kühlkörper (90) aufweisen.

2. Leistungshalbleitermodul (10) nach Anspruch 1,
wobei das Gehäuse (3) mittels einer Klebeverbindung und / oder einer Schnapp-Rast- Verbindung auf dem Randbereich (26) der Seitenwände (24) der Wanne angeordnet ist.

3. Leistungshalbleitermodul (1) nach Anspruch 1,
wobei die Fortsetzungen (36) bis zum Bodenbereich (20) des Grundkörpers (2) reichen und dieser ebenfalls eine Ausnehmung (22) aufweist, und / oder die Fortsetzungen (36) bis auf das Substrat (5) reichen und das Substrat (5) und der Grundkörper (2) im Bodenbereich (20) Ausnehmungen (22, 56) aufweisen.

4. Leistungshalbleitermodul (1) nach Anspruch 1,
wobei der Grundkörper (2) des Leistungshalbleitermoduls (1) zu dem Kühlkörper (90) und / oder zu dem Substrat (5) mittels einer Klebeverbindung fixiert ist.

5. Leistungshalbleitermodul (1) nach Anspruch 4,
wobei der Isolierstoffkörper (54) des Substrats (5) direkt auf den Bodenbereich (20) des Grundkörper (2) mittels der Klebeverbindung fixiert ist.

6. Leistungshalbleitermodul (1) nach Anspruch 1,
wobei das Gehäuse (3) einstückig ausgebildet ist.

7. Leistungshalbleitermodul (1) nach Anspruch 1,
wobei das Gehäuse (3) die Seitenwände (24) des wannenartigen Teils des Grundkörpers (2) überlappt.

## Claims

1. A power semiconductor module (1) comprising a support base (2) for mounting on a heat sink (90) at least consisting of a housing (3), externally leading connecting elements (40, 60), at least one electrically insulating substrate (5) disposed inside the housing (3) which for its part consists of an insulating material body (54) and a plurality of mutually electrically insulated metallic connecting tracks (52) located on its first principal surface facing away from the support base (2) and at least one power semiconductor component (72) having at least one connecting element (70) located hereon, wherein the support base (2) has a part which is configured in a bowl shape and which surrounds at least one substrate (5) in such a manner that the side walls (24) of this bowl have a greater height than the level height of an insulating compound (80) inside the bowl, which therefore surrounds the at least one power semiconductor component (72) and the at least one connecting element (70) and wherein the housing (3) touches the side walls of the bowl at the edge zone or at the outer surface, with the result that the housing acts as a cover of the power semiconductor module and furthermore has extensions (36) into the interior of the power semiconductor module (1) and these extensions (36) have a through recess for disposing a screw connection for fastening the power semiconductor module (1) on the heat sink (90).

2. The power semiconductor module (1) according to claim 1, wherein the housing (3) is disposed by means of an adhesive connection and/or a snap-action latching connection on the edge zone (26) of the side walls (24) of the bowl.

3. The power semiconductor module (1) according to claim 1, wherein the extensions (36) extend as far as the base region (20) of the support base (2) and this also has a recess (22) and/or the extensions (36) extend as far as the substrate and the substrate (5) and the support base (2) have recesses (22, 56) in the base region (20).

4. The power semiconductor module (1) according to claim 1, wherein the support base (2) of the power semiconductor module (1) is fixed to the heat sink (90) and/or to the substrate (5) by means of an adhesive connection.

5. The power semiconductor module (1) according to claim 4, wherein the insulating material body (54) of the substrate (50 is fixed directly on the base region (20) of the support base (2) by means of the adhesive connection.

6. The power semiconductor module (1) according to claim 1, wherein the housing (3) is configured as one-piece.

7. The power semiconductor module (1) according to claim 1, wherein the housing (3) overlaps the side walls (24) of the bowl-shaped part of the support base (2).

## Revendications

1. Module semi-conducteur de puissance (1) comprenant un corps de base (2) pour le montage sur un corps de refroidissement (90) comprenant au moins un boîtier (3), des éléments de raccordement (40, 60) allant vers l'extérieur, au moins un substrat (5) électro-isolant disposé à l'intérieur du boîtier (3), qui pour sa part comprend un corps en matériau isolant (54) et une pluralité de bandes de liaison (52) métalliques, isolées électriquement les unes par rapport aux autres, se trouvant sur la première surface principale, opposée au corps de base (2), du corps isolant, disposée dessus au moins un composant semi-conducteur de puissance (72) avec au moins un élément de liaison (70), le corps de base (2) présentant une partie qui est conçue en forme de cuve qui entoure au moins un substrat (5) de telle sorte que les parois latérales (24) de cette cuve présentent une hauteur plus grande que la hauteur de niveau d'une masse d'isolation (80) à l'intérieur de la cuve, qui entoure ainsi également l'au moins un composant semi-conducteur de puissance (72) et l'au moins un élément de liaison (70), et
le boîtier (3) touchant les parois latérales de la cuve sur la zone périphérique ou sur la surface extérieure, le boîtier agissant comme couvercle du module semi-conducteur de puissance et présentant également des prolongements (36) à l'intérieur du module semi-conducteur de puissance (1), et ces prolongements (36) présentent un évidement continu pour la mise en place d'un assemblage vissé pour la fixation du module semi-conducteur de puissance (1) sur le corps de refroidissement (90).

2. Module semi-conducteur de puissance (1) selon la revendication 1,
le boîtier (3) étant disposé au moyen d'un assemblage collé et/ou d'un assemblage à emboîtement et encliquetage sur la zone périphérique (26) des parois latérales (24) de la cuve.

3. Module semi-conducteur de puissance (1) selon la revendication 1,
les prolongements (36) allant jusqu'à la zone de fond (20) de corps de base (2) et cette zone présentant également un évidement (22), et/ou les prolongements (36) allant jusqu'au substrat (5) et le substrat (5) et le corps de base (2) présentant des évidements (22,56) dans la zone du fond (20).

4. Module semi-conducteur de puissance (1) selon la revendication 1,
le corps de base (2) du module semi-conducteur de puissance (1) étant fixé avec le corps de refroidissement (90) et/ou le substrat (5) au moyen d'un assemblage collé.

5. Module semi-conducteur de puissance (1) selon la revendication 4,
le corps en produit isolant (54) du substrat (5) étant fixé directement sur la zone de fond (20) du corps de base (2) au moyen de l'assemblage collé.

6. Module semi-conducteur de puissance (1) selon la revendication 1,
le boîtier (3) étant conçu d'une seule pièce.

7. Module semi-conducteur de puissance (1) selon la revendication 1,
le boîtier (3) recouvrant les parois latérales (24) de la partie en forme de cuve du corps de base (2).
